# EUROPEAN PATENT APPLICATION

(11) **EP 1 553 420 A1**
(43) Date of publication of application: **13.07.2005**
(21) Application number: 04396081.4
(22) Date of filing: 15.12.2004
(51) Int. Cl.: G01R 15/18

(54) **Current transformer for metering alternating current**

(30) Priority: 09.01.2004 FI 20040018
(71) Applicant: ENERMET OY, 40420 Jyskä (FI)
(72) Inventor: Lohvansuu, Juha, 40720 Jyväskylä (FI)
(74) Representative: Stellberg, Hans

(57) **Abstract**

The current transformer comprises a primary circuit formed of at least one primary current conductor (10) having an output branch (11), a return branch (12) and a current loop (13) connecting these and a secondary circuit formed of at least one gradiometer (20) of at least the second order and formed in at least one conducting layer of a printed circuit board. Alternating current travelling in the current loop (13) of the primary current conductor (10) generates around it a magnetic field, which is connected to said at least one gradiometer (20) of at least the second order generating therein a voltage signal to be metered. The output branch (11), the return branch (12) of said at least one primary current conductor (10) and the current loop (13) connecting them are formed in one and the same conducting layer of the printed circuit board in such a way that in between said at least one primary current conductor (10) and said at least one gradiometer (20) of at least the second order there is at least one conducting layer, which forms a static shield between the primary circuit and the secondary circuit.

## Description

The invention concerns a current transformer for metering alternating current in accordance with the preamble to Claim 1.

The current transformer according to the invention is especially suitable for such current metering, which takes place in a kWh meter.

In a kWh meter, great dynamics, a good interference tolerance and a good linearity are required of the current metering. In addition, the current transformer must be insensitive to any direct current occurring in the primary conductor. Current metering is based more generally on a resistance turning the current into voltage, on a current transformer having an iron or ferrite core, on an induction phenomenon, wherein the primary current induces a voltage in the secondary coil, on magnetic sensors (for example, a Hall sensor or a magnetoresistive sensor) or, in some cases, on an optical fibre sensing a magnetic field. Except in transformers based on resistance, metering is based in all transformers in some way or other on utilisation of a magnetic field brought about by the current. Good and bad features are associated with the different methods. The traditional transformer is big and tolerates no direct current, so it is being abandoned in modem kWh meters.

The current transformer according to the invention is based on inductive current metering. In inductive current metering, the alternating current to be metered is connected to travel through a suitable primary conductor or primary conductor system, whereby the current travelling in the primary conductor will generate around itself a magnetic field changing as a function of time and place. A suitable secondary coil or secondary coil system is connected to be in connection with this primary current conductor. The magnetic field generated by the primary current conductor and changing as a function of time and place generates a voltage in the secondary coil, which voltage is proportional to the rate of change of the current travelling in the primary current conductor, that is, to the current's derivative in relation to time.

In current transformers of this kind, a gradiometer may be used as a secondary coil. The gradiometer is an element recognising the magnetic field and having an output providing a secondary signal proportional to the gradient of the magnetic field. Gradiometers are used when metering weak magnetic fields in an environment where interferences occur, because the gradiometer will suppress the impact of external interfering magnetic fields.

The gradiometer's order means that derivative of the lowest grade, which can be metered by the gradiometer in question. A gradiometer of the zero order, that is, the magnetometer, meters a constant field in relation to the place only. A gradiometer of the first order again gives the difference between the magnetic flux densities metered at two points. At the same time, the structure also annuls any external interference, if it is constant in relation to the place, that is, the interference is of the same magnitude at all magnetic field sensors. Thus, a gradiometer of the first order annuls a zero-order derivative of an external interference, that is, a homogeneous external interference. A gradiometer of the second order can be used for metering a magnetic field's 2^{nd} derivative and it can be used to annul an interference field, which is constant in relation to the place or linearily changing (0 and 1 derivative) etc. In a gradiometer of order N, there must be at least N+1 magnetic field sensors.

**FI Patent 98865** presents a method for metering alternating current based on a gradiometer. In this method, a gradiometer at least of the first order is fitted inside or immediately adjacent to a primary current conductor system, whereby the current travelling in the primary current system will induce a voltage in the gradiometer. The shape of the current conductor system and the shape of the coil structure of the gradiometer are matched in such a way that the output signal will be essentially independent of any minor changes occurring in the relative position of the current conductor system and the gradiometer.

**FI Patent 108165** presents another current transformer for metering alternating current based on a gradiometer. The current transformer comprises a primary current conductor, where there are two current loops of essentially circular shape and connected in parallel and at least one gradiometer having the shape of an essentially planar circle. The current loops of the primary current conductor are located concentrically one on top of the other in parallel planes located at a distance from each other. Said at least one gradiometer is located in between the current loops in a plane parallel to the current loop planes. The primary current travelling in the current loops of the primary current conductor is connected with the aid of a magnetic field to said at least one gradiometer, where it generates a voltage proportional to the primary current. Said at least one gradiometer is formed in a conducting layer of a printed circuit board, but the primary current conductor is formed of a separate part. The printed circuit board is located in between the current loops of the primary current conductor in such a way that the center of the gradiometer or the centers of the gradiometers are located along a line segment connecting the centers of the primary current conductor's current loops.

**WO patent publication 97/13156 (US Patent 5,736,846)** presents an inductive current transformer intended especially for monitoring an alarm system in a building. The current transformer is connected to an electric circuit connected to every loudspeaker of the alarm system, whereby it is used for monitoring an audio signal in the form of alternating current travelling to every loudspeaker of the alarm system. Should an interference occur in some part of the alarm system, for example, in case of a fire in some part of the building, it is important to know whether the loudspeakers of the alarm system are functioning or not in the concerned part of the building. With a current transformer connected to the electric circuit of every loudspeaker, information is obtained at all times on the operation of every loudspeaker. The current transformer has a primary circuit and a secondary circuit. In the primary circuit there is at least one short elongated current conductor element, through which the current to be metered is conducted. The secondary circuit includes at least a first coil, which is connected inductively at least to a part of the current conductor element, and preferably a second coil connected inductively to another part of the current conductor element. The secondary coils are connected in series in such a way that the voltages induced by the primary current conductor in the secondary coils will be summed and voltages induced by homogeneous external magnetic fields in the secondary coils will be annulled. This means that the secondary coils constitute a gradiometer of the first order. Each secondary coil is formed by a disc coil having two parallel long sides and semicircles connecting these at both ends. The current conductor element is parallel to the long side of the secondary coil and the current conductor element is located immediately adjacent to the other long side of the secondary coil either directly above it or directly below it.

**WO patent publication 97/13156** presents a current transformer, which can be formed in a four-layer printed circuit board in such a way that a primary current conductor is formed in the first conducting layer of the printed circuit board and in the fourth conducting layer of the printed circuit board. The first coil of the secondary circuit is formed in the second layer of the printed circuit board and the second coil of the secondarycircuit is formed in the third layer of the printed circuit board. There is an insulating layer in between the printed circuit board's first and second, second and third and third and fourth conducting layers. Thus, there is no static protection between the primary current conductor and the secondary coils that would prevent any capacitive connection of the primary current conductors to the secondary coils. One primary current conductor is formed by a first current conductor element formed in the printed circuit board's first conducting layer and of a second current conductor element formed in the printed circuit board's fourth layer. The first and second current conductor elements are connected in parallel in such a way that the current to be metered is divided between them, whereby the first sub-current travelling in the first current conductor element and the second sub-current travelling in the second current conductor element will travel in the same direction.

It is an objective of the invention to provide a simple and reliable current transformer for metering alternating current based on inductive current metering. In addition, the current transformer according to the invention must also be suitable for mass production and it must have sufficient dynamics for current metering.

The objectives of the invention are achieved by the current transformer in accordance with the characterizing part of Claim 1.

In the solution according to the invention, the current transformer's primary current conductor and at least one gradiometer of the first order functioning as a secondary coil are formed on a Printed Circuit Board, PCB. This can be made, for example, in a four-layer printed circuit board, that is, in a printed circuit board having four conducting layers and an insulating layer in between each conducting layer. The primary current conductor is formed in the first conducting layer of the printed circuit board, the first gradiometer of the secondary circuit is formed in the third conducting layer of the printed circuit board and the second gradiometer of the secondary circuit is formed in the fourth conducting layer of the printed circuit board. The second conducting layer of the printed circuit board forms a static shield between the primary current conductor and the secondary circuit to prevent any capacitive connection of the primary current conductor to the gradiometers.

The gradiometer's damping formed on the printed circuit board on the homogeneous magnetic field is very effective (over 1000). Thus, the homogeneous magnetic field will not cause any errors in the current transformer's output signal. When using a gradiometer of the second order, the current transformer is insensitive also to a field whose change is linear as a function of the place. Thus, a current transformer based on a gradiometer of the second order will not be disturbed even by a powerful interference field. Since the current transformer's operation is based on the induction phenomenon, it will not be affected by a uniform magnetic field generated by the current conductor's direct current or by any external uniform magnetic field. The current transformer's interference suppression can be improved further by installing a magnetic screen around the current transformer.

If the current and voltage to be metered are high, it is possible to use a gradiometer of the second order. If the current and voltage to be metered are low, one may possibly use a gradiometer of the third, fourth, fifth or even sixth order. Of course, with a growing order the system will become more complicated.

When forming both the primary circuit and the secondary circuit on the printed circuit board, the current transformer can be made compact and with a very small size. The distance between the primary circuit and the secondary coils is made very short and the structure will be stable. Neither the primary current conductor nor the secondary circuit will move practically at all in relation to each other in the direction of the plane of the printed circuit board.

When the primary current conductor is formed on the printed circuit board, it can be made even with a very complicated shape, if required. The technique of manufacturing the printed circuit board allows making a complicated shape in such a way that a good reproducibility is preserved. The primary current conductor can hereby be made with such a shape that there will be as powerful gradients as possible in the magnetic field, which it generates. The shape and dimension of the gradiometric secondary coil may for their part be matched with the magnetic field produced by the primary current conductor in such a way that the gradients of the magnetic field will generate a high voltage in the secondary circuit. Even a complex gradiometer can be formed on the printed circuit board, easily and with a good reproducibility.

The higher the order of the gradiometer used as secondary circuit, the better it will suppress external magnetic fields. At the same time it will also suppress the magnetic field generated by the primary current conductor. Thus, a gradiometer of a higher order requires a primary current conductor of a more complicated shape, so that gradients of sufficient power and connecting to the gradiometer can be produced at the proper places with the primary current conductor. It is hereby very important to match the primary current conductor and the gradiometer with one another. The primary current conductor and the gradiometer must be located exactly in the correct place in relation to each other and any motion of them in relation to each other must be brought to a minimum. This is made possible by forming the primary current conductor and the gradiometer on a printed circuit board.

The small physical dimensions of the primary current conductor and the secondary circuit also contribute to the current transformer's successful suppression of any external non-homogeneous AC interference field.

The current loop of the primary current conductor preferably forms a circular symmetrical uniform magnetic field connecting well to the gradiometer of at least the second order, which is used as secondary circuit.

In principle, the dynamics of the current transformer according to the invention are sufficient for a range of 5 mA - 200 A. However, the conducting layer of the printed circuit board is very thin, which means that the primary current conductor must be made broad, so that it will not become too hot with high currents. A primary current conductor of an approximate width of 1 cm will withstand a primary current of approximately 10 A without becoming too hot. The primary current tolerance can be improved by forming the primary current conductor in several layers of the printed circuit board and by connecting the primary current conductors thus formed in parallel. The primary current will hereby be divided between several primary current conductors.

The invention will be described in more detail with reference to some advantageous embodiments of the invention, which are shown in the figures of the accompanying drawings. However, the invention is not limited to these embodiments only.

Figure 1 schematically shows a primary current conductor suitable for the current transformer according to the invention.

Figure 2 schematically shows a gradiometer suitable for the current transformer according to the invention.

Figure 3 is a schematic cross-sectional view of a four-layer printed circuit board, wherein a current transformer according to the invention is formed.

Figure 4 schematically shows an electric connection in a situation, where the secondary circuit is formed by two gradiometers according to Figure 2.

Figure 5 schematically shows another primary current conductor suitable for the current transformer according to the invention.

Figure 6 schematically shows a primary current conductor forming a pair with the primary current conductor shown in Figure 5.

Figure 7 schematically shows another gradiometer suitable for the current transformer according to the invention.

Figure 8 is a schematical cross-sectional view of an eight-layer printed circuit board, wherein another current transformer according to the invention is formed.

Figure 9 schematically shows an electric connection in a situation where the secondary circuit is formed by four gradiometers according to Figure 7.

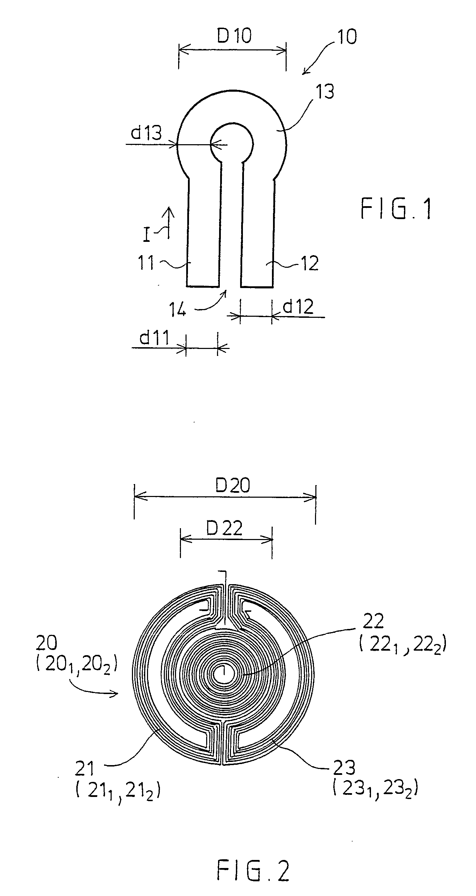

The primary current conductor 10 shown in Figure 1 comprises an output branch 11, a return branch 12 and a current loop 13 connecting them. The input branch 11 and the return branch 12 are formed by pieces of a substantially rectangular shape. The output branch 11 and the return branch 12 are in parallel and in between them there is a narrow gap 14 insulating the output branch 11 from the return branch 12. The current loop 13 connecting one end of the output branch 11 and the return branch 12 is substantially of a circular shape. The thickness of the output branch 11, the return branch 12 amd the curent loop 13 depends on the thickness of the conducting layer in the printed circuit board. The outside diameter D10 of the current loop 13 of the primary current conductor 10 is within a range of 5-20 mm, preferably 14 mm. The current loop's 13 width d13, the output branch's 11 width d11 and the return branch's 12 width d12 are equal and within a range of 2-20 mm, preferably 4 mm. The output branch 11 and the return branch 12 must have a definite length in order to bring about a sufficient overvoltage tolerance between the secondary circuit and the voltage affecting the connecting conductors to be connected to the branches 11, 12 of the primary current conductor 10.

The alternating current I to be metered is conducted to the output branch 11 of the primary current conductor 10, from which it circulates by way of current loop 13 to the return branch 12 and from this further to the place of consumption. Thus, the primary current conductor 10 forms a loop, wherein the current I to be metered does a round and then goes on further to the place of consumption.

The gradiometer 20 shown in Figure 2 comprises a central coil 22 wound in a spiral-like fashion in a plane and two side coils 21, 23 wound in a plane around the outer periphery of the central coil 22, symmetrically along the outer borders of a semi-circle segment. The central coil 22 and the side coils 21, 23 are located in the same plane. The gradiometer 20 is a gradiometer of the second order, which can be formed on a printed circuit board.

The outer diameter D20 of the gradiometer 20 is within a range of 10-30 mm, preferably 22 mm, and the outer diameter D22 of the central coil 22 is within a range of 5-18 mm, preferably 11 mm. The width of the gradiometer's current conductor is within a range of 50-300 µm, preferably 150 µm. The number of turns in the gradiometer's 20 central coil 22 is within a range of 5-50, preferably 12, and the number of turns in each side coil 21, 23 is within a range of 1-20, preferably 5. The effective area of the central coil 22 is equal to the effective area of one side coil 21, 23, whereby the output of the gradiometer is zero in a homogeneous AC magnetic field. The effective area of each coil 21, 22, 23 in the gradiometer 20 is calculated by summing the area of each separate coil turn Aₜₒₜ=A_{1.turn}+A_{2.turn}+A_{3.turn}+...+A_{n.turn}.

The gradiometer 20 is dimensioned so that the central coil 22 is located mainly within an area, where the magnetic field produced by the primary current conductor 10 is positive B > 0. The side coils 21, 23 again are mainly located within an area, where the magnetic field is negative B < 0.

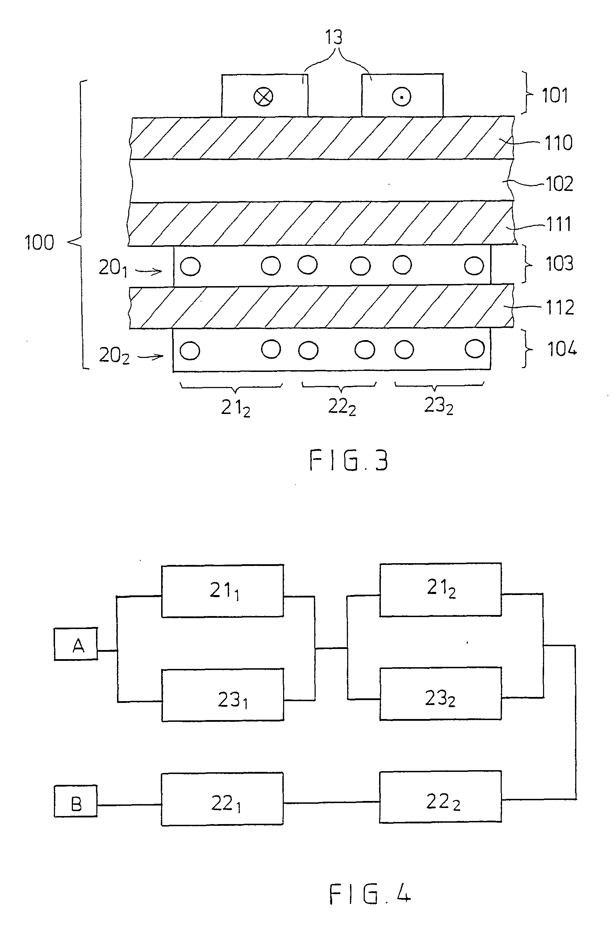

The printed circuit board 100 shown in Figure 3 is formed successively by a conducting layer 101, 102, 103, 104 and an insulating layer 110, 111, 112, and speaking of the printed circuit board's 100 layer this always means a conducting layer in the printed circuit board 100. In the first layer 101 of the printed circuit board 100, which is the outer conducting layer of the printed circuit board, a primary current conductor 10 shown in Figure 1 is formed, of which a current loop 13 can be seen. The printed circuit board's 100 second layer 102 forms a static shield preventing any capacitive connection of the primary circuit 10 with the secondary circuit 20. In the printed circuit board's 100 third layer 103 a gradiometer 20 shown in Figure 2 is formed, which constitutes the current transformer's first gradiometer 20₁. In the printed circuit board's fourth layer 104 a gradiometer 20 as shown in Figure 2 is again formed, which constitutes the current transformer's second gradiometer 20₂. The first side coil 21₂, the central coil 22₂ and the second side coil 23₂ of the gradiometers are also entered in the figure.

Thus, the primary current conductor 10 located in the printed circuit board's 100 first layer 101, the first gradiometer 20₁ located in the third layer 193 and the second gradiometer 20₂ located in the fourth layer 104 are located in parallel planes on top of each other. In addition, the current loop 13 of the primary current conductor 10, the first gradiometer 20₁ and the second gradiometer 20₂ are located concentrically on top of each other, whereby a line segment passing through the central point of the primary current conductor's 10 current loop 13 and the central points of the central coils 22₁, 22₂ of gradiometers 20₁, 20₂ will form a normal to the printed circuit board 100.

The alternating current I to be metered generates in the primary current conductor's 10 current loop 13 a circular symmetrical magnetic field, which induces in the gradiometers 20₁, 20₂ a voltage proportional to the primary current I.

In the connection shown in Figure 4 the weight value of the central coils 22₁, 22₂, is 1 due to the series connection and and the weight value of the side coils 21₁, 23₁, 21₂, 23₂ is 0,5 due to the connection in parallel.

Figure 4 shows a possibility of connecting the first 20₁ and the second 20₂ gradiometers forming the current transformer's secondary circuit and formed in the third 103 and fourth 104 layers of the printed circuit board 100 shown in Figure 3. The current transformer's secondary circuit is connected to amplifier electronics (not shown in the figures) by way of connecting points A and B of the secondary circuit. From connecting point A you move to the outer peripheries of side coils 21₁, 23₁ of the first gradiometer 20₁ located in the third layer, which side coils 21₁, 23₁ are connected in parallel. In the side coils 21₁, 23₁ of the first gradiometer 20₁ you move clockwise to the inner peripheries of the side coils 21₁, 23₁. Then you move on to the inner peripheries of the side coils 21₂, 23₂ of the second gradiometer 20₂ located in the fourth layer, which side coils 21₂, 23₂ are also connected in parallel. In the side coils 21₂, 23₂ of the second gradiometer 20₂ you move clockwise to the outer peripheries of the side coils 21₂, 23₂, whereby you arrive at the outer periphery of the central coil 22₂ of the second gradiometer 20₂. From the side coils of the second gradiometer 20₂ you move on to the outer periphery of the central coil 22₂ of the second gradiometer 20₂, from which you move counter-clockwise to the inner periphery of the central coil 22₂ of the second gradiometer 20₂. From the inner periphery of the central coil 22₂ of the second gradiometer 20₂ you move on to the inner periphery of the central coil 22₁ of the first gradiometer 20₁, from which you move on in a counter-clockwise direction to the outer periphery of the central coil 22₁ of the first gradiometer 20₁. Then you arrive at the second connecting point B.

Each coil 21₁, 22₁, 23₁ of the first gradiometer 20₁ located in the third layer forms a mirror image of the corresponding coil 21₂, 22₂, 23₂ of the second gradiometer 20₂ located in the fourth layer.

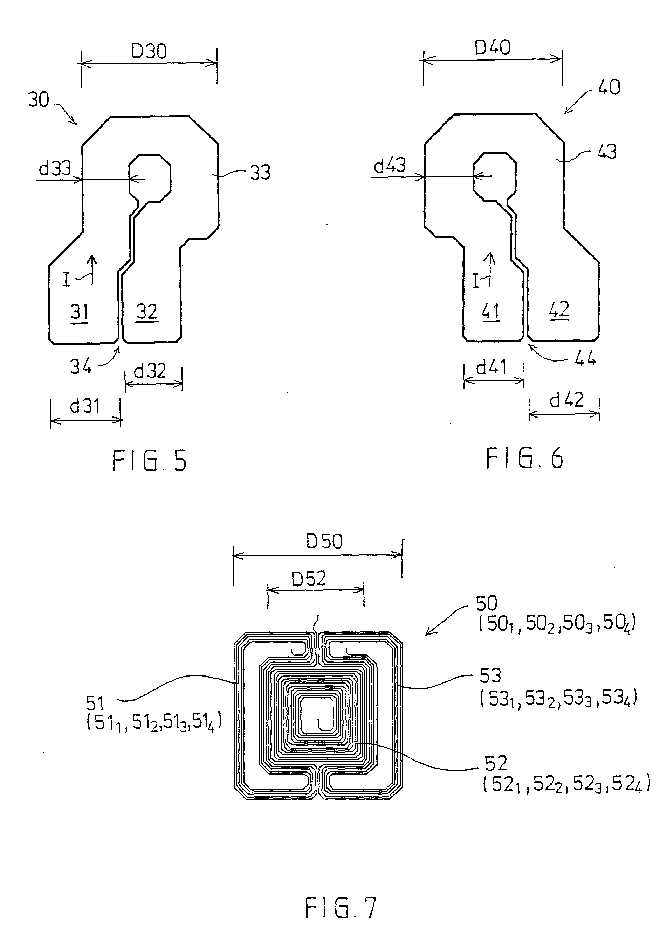

The alternative primary current conductor 30 shown in Figure 5 comprises an output branch 31, a return branch 32 and a current loop 33 connecting these. The input branch 31 and the return branch 32 are not formed by pieces of quite rectangular shape as in the embodiment of Figure 1. Here the shape of the input branch 31 and the output branch 32 is not determined so much on electrotechnical grounds, but the important aspect mainly concerns fitting of the printed circuit board and of the other components to be placed on it. Between the output branch 31 and the return branch 32 there is a narrow gap 34, which insulates the output branch 31 from the return branch 32. The current loop 33 connecting the output branch 31 to the return branch 32 at the other ends is of a substantially rounded quadratic shape. The thickness of the output branch 31, the return branch 32 and the current loop 33 depends on the thickness of the conducting layer in the printed circuit board. The outside diameter D30 of the primary current conductor's 30 current loop 33 is within a range of 10-30 mm, preferably 18 mm, and its width d33 is within a range of 4-10 mm, preferably 6 mm. The width d31 of the output branch 31 is within a range of 5-15 mm, preferably 9 mm, and the width d32 of the return branch 32 is within a range of 5-15 mm, preferably 7 mm.

The alternative primary current conductor 40 shown in Figure 6 is intended for use together with the primary current conductor 30 shown in Figure 5. The primary current conductor 40 comprises an output branch 41, a return branch 42 and a current loop 43 connecting these. The input branch 41 and the return branch 42 are formed by pieces of a polygonal shape. Between the output branch 41 and the return branch 42 there is a narrow gap 44, which insulates the output branch 41 from the return branch 42. The current loop 43 connecting the output branch 41 to the return branch 42 at the other ends is substantially of a quadratic shape. The width d1 of the current loop 43 is somewhat smaller than the width d2, d3 of the output branch 41 and the return branch 42. The thickness of the output branch 41, the return branch 42 and the current loop 43 depends on the thickness of the conducting layer in the printed circuit board. The outer diameter D40 of the primary current conductor's 40 current loop 43 is within a range of 10-30 mm, preferably 18 mm, and its width d43 is within a range of 4-15 mm, preferably 6 mm. The width d41 of the output branch 41 is within a range of 5-15 mm, preferably 7 mm, and the width d42 of the return branch 42 is within a range of 5-15 mm, preferably 9 mm.

The output branches 31, 41 and the return branches 32, 42 of the primary current conductors shown in Figure 5 and in Figure 6 are shaped in such a way that the primary current conductors can be placed superimposed in the outer layers of the printed circuit board and connected in series. The current I to be metered is supplied to the output branch 31 of the first primary current conductor 30, from which it circulates to the current loop 33 of the first primary current conductor 30 and returns from the return branch 32 of the first primary current conductor 30. From the return branch 32 of the first primary current conductor 30 the current I is conducted to the ouput branch 41 of the second primary current conductor 40, from which it circulates to the current loop 43 of the second primary current conductor 40 and returns from the return branch 42 of the second primary current conductor 40.

The alternative secondary circuit 50 shown in Figure 7 is also a gradiometer of the second order. This gradiometer 50 is formed of a central coil 52 wound in a spiral-like fashion in a plane around a square and of two side coils 51,53 wound along the outer borders of a resting letter U around the outer borders of the central coil 52. All three coils 51, 52, 53 of the gradiometer 50 are located in the same plane.

The outside diameter D50 of the gradiometer 50 is within a range of 10-30 mm, preferably 22 mm, and the outside diameter D52 of the central coil 52 is within a range of 5-20 mm, preferably 12 mm. The width of the current conductor of the gradiometer 50 is within a range of 50-300 µm, preferably 150 µm. The number of turns in the central coil 52 of the gradiometer 50 is within a range of 5-50, preferably 12, and the number of turns in each side coil 21, 23 is within a range of 1-20, preferably 5. The effective area of the central coil 52 is equal to the total effective area of both side coils 51, 53, whereby the gradiometer's output is zero in a homogeneous AC magnetic field.

The gradiometer 50 is dimensioned so that the central coil 52 is located mainly in an area where the magnetic field produced by the primary current conductor 30, 40 is positive B > 0. The side coils 51, 53 for their part are mainly located in an area where the magnetic field is negative B < 0.

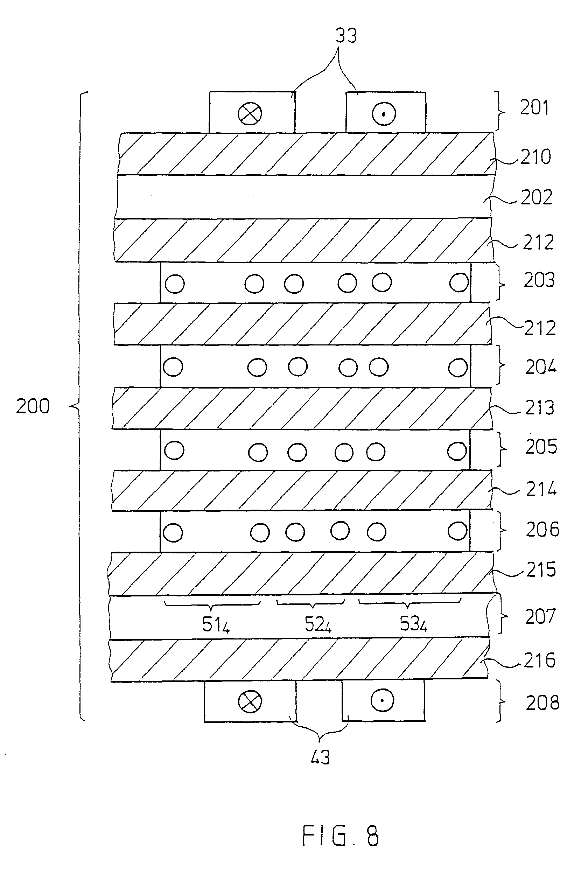

The eight-layer printed circuit board 200 shown in Figure 8 is formed in turns by a conductive layer 201, 202, 203, 204, 205, 206, 207, 208 and an insulating layer 210, 211, 212, 213, 214, 215, 216. In the first layer 201 of the printed circuit board 200, which is the outer conducting layer of the printed circuit board's first surface, a primary current conductor 30 shown in Figure 5 is formed. In the eighth layer 208 of the printed circuit board 200, which is the outer conducting layer of the printed circuit board's second surface, a current conductor 40 shown in Figure 6 is formed. The printed circuit board's 200 second layer 202 and seventh layer 207 form a static shield, which is used to prevent the primary circuit from being connected capacitively to the secondary circuit. In the printed circuit board's third 203, fourth 204, fifth 205 and sixth 206 layers a gradiometer 50 as shown in Figure 7 is formed. The gradiometer located in the third layer 203 forms the current transformer's first gradiometer 50₁, the gradiometer located in the fourth layer 204 forms the current transformer's second gradiometer 50₂, the gradiometer located in the fifth layer 205 forms the current transformer's third gradiometer 50₃, the gradiometer located in the sixth layer 206 forms the current transformer's fourth gradiometer 50₄.

Thus, the first primary current conductor 30 located in the printed circuit board's 200 first layer 201, the second primary current conductor 40 located in the eighth layer 208, the first gradiometer 50₁ located in the third layer 203, the second gradiometer 50₂ located in the fourth layer 204, the third gradiometer 50₃ located in the fifth layer 205 and the fourth gradiometer 50₄ located in the sixth layer are located in parallel planes on top of each other. In addition, the current loops 33, 43 of the primary current conductors 30, 40, the first gradiometer 50₁, the second gradiometer 50₂, the third gradiometer 50₃ and the fourth gradiometer 50₄ are located concentrically on top of each other, whereby a line segment passing through the centres of the current loops 33, 43 of primary current conductors 30, 40 and the centres of the central coils 52₁, 52₂, 52₃, 52₄ of gradiometers 50₁, 50₂, 50₃, 50₄ forms a normal to the printed circuit board 200.

In the current loops 33, 43 of primary current conductors 30, 40, the alternating current I to be metered generates a magnetic field of an almost circular symmetric shape, which in the gradiometers 50₁, 50₂, 50₃, 50₄ induces a voltage proportionate to the primary current I.

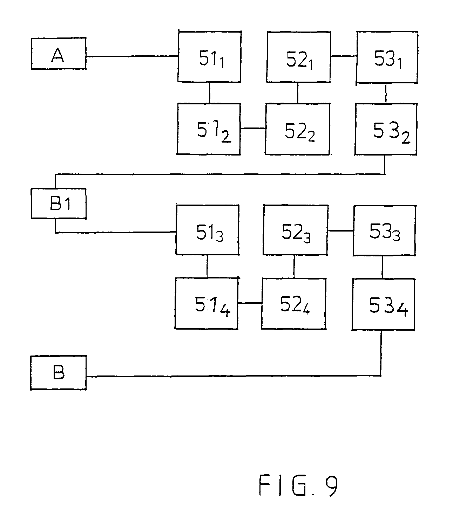

Figure 9 shows a possibility of connecting the gradiometer formed in the third 50₁, fourth 50₂, fifth 50₃ and sixth 50₄ layers shown in Figure 8 and forming the current transformer's secondary circuit. The current transformer's secondary circuit is connected to amplifier electronics (not shown in the figures) by way of the connecting points A and B of the secondary circuit. From connecting point A you move on to the outer periphery of the first side coil 51₁ of the first gradiometer 50₁ located in the third layer 203, from which you move on in a counter-clockwise direction to the inner periphery of the first side coil 51₁ of the first gradiometer 50₁. Next, you move to the inner periphery of the first side coil 51₂ of the second gradiometer 50₂ located in the fourth layer 204, from which you move on in a counter-clockwise direction to the outer periphery of the first side coil 51₂ of the second gradiometer 50₂. Next, you move to the outer periphery of the central coil 52₂ of the second gradiometer 50₂ located in the fourth layer 204, from which you move on in a clockwise direction to the inner periphery of the central coil 52₂ of the second gradiometer 50₂. Next, you move to the inner periphery of the central coil 52₁ of the first gradiometer 50₁ located in the third layer 203, from which you move in a clockwise direction to the outer periphery of the central coil 52₁ of the first gradiometer 50₁. Next, you move to the outer periphery of the second side coil 53₁ of the first gradiometer 50₁ located in the third 203 layer, from which you move in a counter-clockwise direction to the inner periphery of the second side coil 53₁ of the first gradiometer 50₁. Next, you move to the inner periphery of the second side coil 53₂ of the second gradiometer 50₂ located in the fourth layer 204, from which you move in a counter-clockwise direction to the outer periphery of the second side coil 53₂ of the second gradiometer 50₂. After this, you arrive at an intermediate point B1.

From the intermediate point B1 you move to the outer periphery of the first side coil 51₃ of the third gradiometer 50₃ located in the fifth layer 205, from which you move in a counter-clockwise direction to the inner periphery of the first side coil 51₃ of the third gradiometer 50₃. Next, you move to the inner periphery of the first side coil 51₄ of the fourth gradiometer 50₄ located in the sixth layer 206, from which you move in a counter-clockwise direction to the outer periphery of the first side coil 51₄ of the fourth gradiometer 50₄. Next, you move to the outer periphery of the central coil 52₄ of the fourth gradiometer 50₄ located in the sixth layer 206, from which you move in a clockwise direction to the inner periphery of the central coil 52₄ of the fourth gradiometer 50₄. Next, you move to the inner periphery of the central coil 52₃ of the third gradiometer 50₃ located in the fifth layer 205, from which you move in a clockwise direction to the outer periphery of the central coil 52₃ of the third gradiometer 50₃. Next, you move to the outer periphery of the second side coil 53₃ of the third gradiometer 50₃ located in the fifth layer 205, from which you move in a counter-clockwise direction to the inner periphery of the second side coil 53₃ of the third gradiometer 50₃. Next, you move to the inner periphery of the first side coil 51₄ of the fourth gradiometer 50₄ located in the sixth layer 206, from which you move in a counter-clockwise direction to the outer periphery of the first side coil 51₄ of the fourth gradiometer 50₄. After this, you arrive at an intermediate connecting point B.

In the connection shown in Figure 9, the weight value of all the coils 51₁, 52₁, 53₁, 51₂, 52₂, 53₂, 51₃, 52₃, 53₃, 51₄, 52₄, 53₄ is 1, because all coils are connected in series.

Each coil 51₁, 52₁, 53₁ in the first gradiometer 50₁ located in the third layer forms a mirror image with the corresponding coil 51₂, 52₂, 53₂ of the second gradiometer 50₂ located in the fourth layer. In a similar manner, each coil 51₃, 52₃, 53₃ in the third gradiometer 50₃ located in the fifth layer forms a mirror image with the corresponding coil 51₄, 52₄, 53₄ of the fourth gradiometer 50₄ located in the sixth layer.

Correspondingly, each coil 51₁, 52₁, 53₁ of the first gradiometer 50₁ located in the third layer is similar to the corresponding coil 51₃, 52₃, 53₃ of the third gradiometer 50₃ located in the fifth layer. Each coil 51₂, 52₂, 53₂ of the second gradiometer 50₂ located in the second layer is also similar to the corresponding coil 51₄, 52₄, 53₄ of the fourth gradiometer 50₄ located in the sixth layer.

In Figure 8, the first 30 and second 40 primary current conductors are connected in series, whereby the magnetic field generated by the primary current I can be amplified approximately to a double value compared with the use of one primary current conductor only. However, the first 30 and second 40 primary current conductors may also be connected in parallel, whereby the primary current I will be divided between these two primary current conductors 30, 40. This division of the primary current I into several sub-currents is required with great currents, so that excessive heating of the thin primary current conductor can be prevented.

In the embodiment shown in Figure 3, two gradiometers 20₁, 20₂ of the second order are used, and in the embodiment shown in Figure 7 four gradiometers 50₁, 50₂, 50₃, 50₄ of the second order are used. The more gradiometers you use, the more powerful a signal, that is, voltage you obtain from the secondary circuit. From the aspect of the invention, only one gradiometer of the second order can be used, if the signal obtained from this one gradiometer is of a sufficient power.

In the embodiments shown in the figures, all three coils of the gradiometer of the second order are formed in one conducting layer of the printed circuit board. From the aspect of the invention, it is also possible that the coils of a gradiometer of the second order are formed in different layers of the printed circuit board, for example, in such a way that the central coil is in one layer while the side coils are in another layer.

A current transformer connected to one phase of an electric network has been presented in the foregoing. In a three-phase kWh meter three such current transformers are needed, one for each phase. All these may be located side by side on the same printed circuit board.

Of course, also other components besides a current transformer or current transformers can be formed on the printed circuit board 100, 200. For example, the whole metering electronics of a kWh meter can be located on one and the same printed circuit board when required.

Only some advantageous embodiments of the invention have been presented in the foregoing, and it is obvious to a person skilled in the art that numerous modifications can be made to these within the scope of the inventive idea defined in the appended claims.

## Claims

1. Current transformer for metering alternating current (I) comprising a primary circuit, which is formed of at least one primary current conductor (10, 30, 40) having an output branch (11, 31, 41), a return branch (12, 32, 42) and a current loop (13, 33, 43) connecting these and a secondary circuit formed of at least one gradiometer (20, 50) of at least the seond order and formed in at least one conducting layer of a printed circuit board, in which current transformer the alternating current (I) to be metered is conducted to the output branch (11, 31, 41) of the primary current conductor (10, 30, 40), from which it circulates through the current loop (13, 33, 43) and returns along the return branch (12, 32, 42), after which the alternating current (I) is conducted to a consumption target, whereby the alternating current (I) passing through the current loop (13, 33, 43) generates a magnetic field around it, which magnetic field is connected to said at least one gradiometer (20, 50) of at least the second order generating therein a voltage signal to be metered, **characterized in that** the output branch (11, 31, 41), the return branch (12, 32, 42) of said at least one primary current conductor (10, 30, 40) and the current loop (13, 33, 43) connecting them are formed in one and the same conducting layer of a printed circuit board in such a way that in between said one primary current conductor (10, 30, 40) and said at least one gradiometer (20, 50) of at least the second order there is at least one conducting layer forming a static shield between the primary circuit and the secondary circuit.

2. Current transformer according to claim 1, **characterized in that** the central point of said at least one gradiometer (20, 50) is concentric with the central point of the current loop (13, 33, 43) of said at least one primary current conductor (10, 30, 40).

3. Current transformer according to claim 1 or 2, **characterized in that** the current transformer comprises one primary current conductor (10) and two gradiometers (20), which are formed in a four-layer printed circuit board (100) in such a way that the primary current conductor (10) is formed in the first conducting layer (101) of the printed circuit board (100), and the first gradiometer (20₁) is formed in the third conducting layer (103) of the printed circuit board (100), and the second gradiometer (20₂) is formed in the fourth conducting layer (104) of the printed circuit board (100), whereby the second conducting layer (102) of the printed circuit board (100) forms a static shield between the primary current conductor (10) and the gradiometer (20₁, 20₂).

4. Current transformer according to claim 3, **characterized in that** each gradiometer (20₁, 20₂) is formed of a central coil (22₁, 22₂) wound in a spiral-like fashion in a plane and of two side coils (21₁, 23₁, 21₂, 23₂) wound in a plane around the outer periphery of the central coil (22₁, 22₂) along the outer borders of a semi-circle segment, whereby all three coils (21₁, 22₁, 22₃, 21₂, 22₂, 23₂) of each gradiometer (20₁, 20₂) are located in the same plane.

5. Current transformer according to claim 4, **characterized in that** the two side coils (21₁, 23₁, 21₂, 23₂) of each gradiometer (20₁, 20₂) are connected in parallel, that the side coil pairs (21₁, 23₁) and (21₂, 23₂) are series-connected and that the central coils (22₁, 22₂) are connected in series with each other and with the side coil pairs.

6. Current transformer according to clain 4 or 5, **characterized in that** the effective area of the central coil (22₁, 22₂) of each gradiometer (20₁, 20₂) is equal to the effective area of one side coil (21₁, 23₁, 21₂, 23₂).

7. Current transformer according to any one of claims 4-6, **characterized in that** the number of turns in the central coils (22₁, 22₂) of each gradiometer (20₁, 20₂) is within a range of 5-50, preferably 12.

8. Current transformer according to any one of claims 4-7, **characterized in that** the number of turns in each side coil (22₁, 23₁, 21₂, 23₂) of each gradiometer (20₁, 20₂) is within a range of 1-20, preferably 5.

9. Current transformer according to claim 1 or 2, **characterized in that** the current transformer comprises two primary current conductors (30, 40) and four gradiometers (50₁, 50₂, 50₃, 50₄), which are formed in an eight-layer printed circuit board (200) in such a way that the first primary current conductor (30) is formed in the first conducting layer (201) of the printed circuit board (200), the second primary current conductor (40) is formed in the eighth conducting layer (208) of the printed circuit board (200), the first gradiometer (50₁) is formed in the third conducting layer (203) of the printed circuit board (200), the second gradiometer (50₂) is formed in the fourth conducting layer (204) of the printed circuit board (200), the third gradiometer (50₃) is formed in the fifth conducting layer (205) of the printed circuit board (200) and the fourth gradiometer (50₄) is formed in the sixth conducting layer (206) of the printed circuit board (200), whereby the second (202) and seventh (207) conducting layers of the printed circuit board (200) form a static shield between the primary current conductors (20, 30) and the gradiometers (50₁, 50₂, 50₃, 50₄).

10. Current transformer according to claim 9, **characterized in that** each gradiometer (50₁, 50₂, 50₃, 50₄) is formed of a central coil (52₁, 52₂, 52₃, 52₄) wound in a spiral-like fashion in a plane around a square and of two side coils (51₁, 53₁, 51₂, 53₂, 51₃, 53₃, 51₄, 53₄) wound in a plane around the outer borders of the central coil (52₁, 52₂, 52₃, 52₄) along the outer borders of a resting letter U, whereby all three coils (51₁, 52₁, 53₁, 51₂, 52₂, 53₂, 51₃, 52₃, 53₃, 51₄, 52₄, 53₄) of each gradiometer (50₁, 50₂, 50₃, 50₄) are located in the same plane.

11. Current transformer according to claim 10, **characterized in that** all three coils (51₁, 52₁, 53₁, 51₂, 52₂, 53₂, 51₃, 52₃, 53₃, 51₄, 52₄, 53₄) of each gradiometer (50₁, 50₂, 50₃, 50₄) are connected in series with each other and that the gradiometers (50₁, 50₂, 50₃, 50₄) are also connected in series with each other.

12. Current transformer according to claim 10 or 11, **characterized in that** the effective area of each side coil (51₁, 53₁, 51₂, 53₂, 51₃, 53₃, 51₄, 53₄) in each gradiometer (50₁, 50₂, 50₃, 50₄) is one-half of the effective area of each central coil (52₁, 52₂, 52₃, 52₄).

13. Current transformer according to any one of claims 10-12, **characterized in that** the number of turns in the central coils (52₁, 52₂, 52₃, 52₄) of each gradiometer (50₁, 50₂, 50₃, 50₄) is within a range of 5-50, preferably 12.

14. Current transformer according to any one of claims 10-13, **characterized in that** the number of turns in each side coil (51₁, 53₁, 51₂, 53₂, 51₃, 53₃, 51₄, 53₄) of each gradiometer (50₁, 50₂, 50₃, 50₄) is within a range of 1-20, preferably 5.
